# EUROPEAN PATENT SPECIFICATION

(11) **EP 4 490 528 B1**
(45) Date of publication and mention of the grant of the patent: **19.08.2026**
(21) Application number: 23715313.5
(22) Date of filing: 10.03.2023
(51) Int. Cl.: G01R 31/367

(54) **SYSTEMS AND METHODS FOR USING ADAPTIVE MODELING TO PREDICT ENERGY SYSTEM PERFORMANCE**
SYSTEME UND VERFAHREN ZUR VERWENDUNG VON ADAPTIVER MODELLIERUNG ZUR VORHERSAGE DER ENERGIESYSTEMLEISTUNG
SYSTÈMES ET PROCÉDÉS D'UTILISATION D'UNE MODÉLISATION ADAPTATIVE POUR PRÉDIRE LES PERFORMANCES D'UN SYSTÈME D'ÉNERGIE

(30) Priority: 10.03.2022 US 202263318561 P; 18.05.2022 US 202263343464 P
(43) Date of publication of application: 15.01.2025
(73) Proprietor: Electra Vehicles, Inc., Boston, MA 02127 (US)
(72) Inventor: RIVKIN, David Aaron, Boston, Massachusetts 02127 (US); TRITSARIS, Georgios, Boston, Massachusetts 02127 (US); COUTURE, Thomas, Boston, Massachusetts 02127 (US); RUFUS, Freeman, Boston, Massachusetts 02127 (US); LIU, Yuxiang, Boston, Massachusetts 02127 (US); MARTINI, Fabrizio, Boston, Massachusetts 02127 (US)
(74) Representative: Hoffmann Eitle
(86) International application number: PCT/US2023/014981
(87) International publication number: WO 2023/172735

(56) References cited:
- US-A1- 2018 143 257
- MOHSENINIA M ET AL: "Perspective-Combining Physics and Machine Learning to Predict Battery Lifetime", 31 December 2021 (2021-12-31), pages 1 - 6, XP093056358, Retrieved from the Internet <URL:https://iopscience.iop.org/article/10.1149/1945-7111/abec55/pdf> [retrieved on 20230621]
- HAO TU ET AL: "Integrating Electrochemical Modeling with Machine Learning for Lithium-Ion Batteries", ARXIV.ORG, CORNELL UNIVERSITY LIBRARY, 201 OLIN LIBRARY CORNELL UNIVERSITY ITHACA, NY 14853, 22 July 2021 (2021-07-22), XP091003071
- KHAN NOMAN ET AL: "Batteries State of Health Estimation via Efficient Neural Networks With Multiple Channel Charging Profiles", IEEE ACCESS, IEEE, USA, vol. 9, 29 December 2020 (2020-12-29), pages 7797 - 7813, XP011831124, DOI: 10.1109/ACCESS.2020.3047732

## Description

### BACKGROUND

Some battery-powered devices, such as electric vehicles, manage their available energy by estimating quantities that characterize the current state of their energy storage system (e.g., batteries). Example quantities that are often used in assessing available energy in a battery-powered device include State of Health (SOH), State of Charge (SOC) and State of Power (SOP). Because the current state of such quantities is not directly measurable, they are typically estimated. Some conventional techniques estimate these properties using a static model of the energy storage system that is determined when the battery-powered device is manufactured. For example, Coulomb counting techniques employed by some battery-powered devices to estimate the current state of their energy storage system use analytical methods to statistically estimate the future state of the battery following manufacture.

Muratahan Aykol et al. "Perspective-Combining Physics and Machine Learning to Predict Battery Lifetime", 2021, J. Electrochem. Soc. 168 030525, describes that forecasting the health of a battery is a modeling effort that is critical to driving improvements in and adoption of electric vehicles. Purely physics-based models and purely data-driven models have advantages and limitations of their own. Considering the nature of battery data and end-user applications, several architectures are outlined for integrating physics-based and machine learning models that can improve our ability to forecast battery lifetime.

Hao Tu et al. "Integrating Electrochemical Modeling with Machine Learning for Lithium-Ion Batteries", 10.48550/arXiv.2103.11580, presents an approach to integrate a physics-based model with machine learning to achieve high-precision modeling for lithium-ion batteries. This approach proposes to inform the machine learning model of the dynamic state of the physical model, enabling a deep integration between physics and machine learning. Two hybrid physics-machine learning models are proposed based on the approach, which blend a single particle model with thermal dynamics with a feedforward neural network to perform physics-informed learning of a lithium-ion batteries dynamic behavior.

NOMAN KHAN et al. "Batteries State of Health Estimation via Efficient Neural Networks with Multiple Channel Charging Profiles", IEEE ACCESS, IEEE, vol. 9, 29 December 2020, pages 7797-7813, proposes a multiple channel charging profiles based battery management system to estimate batteries health/capacity through a deep learning concept where the patterns in these charging profiles are changed as the battery ages with time and cycles.

US 2018/143257 A1 describes that systems and computer-implemented methods are used for analyzing battery information. The battery information may be acquired from both passive data acquisition and active data acquisition. Active data may be used for feature extraction and parameter identification responsive to the input data relative to an electrical equivalent circuit model to develop geometric-based parameters and optimization-based parameters. These parameters can be combined with a decision fusion algorithm to develop internal battery parameters. Analysis processes including particle filter analysis, neural network analysis, and auto regressive moving average analysis can be used to analyze the internal battery parameters and develop battery health metrics. Additional decision fusion algorithms can be used to combine the internal battery parameters and the battery health metrics to develop state-of-health estimations, state-of-charge estimations, remaining-useful-life predictions, and end-of-life predictions for the battery.

### SUMMARY

Accurately estimating one or more performance properties (e.g., SOH, SOC, SOP) for an energy storage system (e.g., a battery) in an electric vehicle or other system (e.g., a robot, a stationary energy storage system) may, among other things, provide the user of the device with accurate information about the current charge state of the device, facilitate the avoidance of a catastrophic failure of the device, and/or improve or optimize control strategies for energy system usage of the device. Some existing techniques for estimating performance properties of an energy storage system rely on models that are not dynamically updated based on current information about the energy storage system, resulting in inaccurate estimates of the performance properties. Some embodiments of the present disclosure improve upon existing techniques for estimating performance properties of an energy storage system by using an adaptive cell model. The adaptive cell model may be configured to estimate the state of one or more performance properties of an energy storage system based on sensor data associated with the energy storage system and prediction values output from a dynamically updated model of the energy storage system.
In some embodiments of the present invention, a computer-implemented method for estimating an energy storage performance property of an energy system is defined by claim 1. Preferred embodiments are defined in the dependent claims.

### BRIEF DESCRIPTION OF THE DRAWINGS

FIG. 1 schematically illustrates an adaptive cell model, in accordance with some embodiments of the present disclosure;
FIG. 2 schematically illustrates incorporation of an adaptive cell model in an energy storage management system, in accordance with some embodiments of the present disclosure;
FIG. 3 is a flowchart of a process for generating an adaptive cell model, in accordance with some embodiments of the present disclosure;
FIG. 4 illustrates example energy storage models that may be used in an adaptive cell model, in accordance with some embodiments of the present disclosure;
FIG. 5 illustrates example energy storage models that may be used in an adaptive cell model and measurement techniques used to parameterize such models, in accordance with some embodiments of the present disclosure;
FIG. 6A illustrates an equivalent circuit model as a type of energy storage model that may be used in an adaptive cell model, in accordance with some embodiments of the present disclosure;
FIG. 6B illustrates measurement data that may be used to parameterize the equivalent circuit model of FIG. 6A;
FIG. 7A illustrates components of a physics-based model as a type of energy storage model that may be used in an adaptive cell model, in accordance with some embodiments of the present disclosure;
FIGS. 7B-7D illustrate examples of mathematical equations that may be included in a physics-based model, in accordance with some embodiments of the present disclosure;
FIG. 8 illustrates properties that may be parameterized in a physics-based model, in accordance with some embodiments of the present disclosure;
FIG. 9 illustrates graphs of battery system performance properties calculated by a physics-based model, in accordance with some embodiments of the present disclosure;
FIG. 10 schematically illustrates examples of machine learning models that may be used to combine response data and response prediction data for an adaptive cell model, in accordance with some embodiments of the present disclosure;
FIG. 11 schematically illustrates a workflow for an adaptive cell model that includes an equivalent circuit model, in accordance with some embodiments of the present disclosure;
FIG. 12 schematically illustrates another workflow for an adaptive cell model that includes an equivalent circuit model, in accordance with some embodiments of the present disclosure;
FIG. 13 schematically illustrates a workflow for an adaptive cell model that includes a physics-based model, in accordance with some embodiments of the present disclosure;
FIG. 14 schematically illustrates a workflow for an adaptive cell model that includes an equivalent circuit model and a physics-based model, in accordance with some embodiments of the present disclosure;
FIG. 15 schematically illustrates examples of different workflow for adaptive cell models that may be used, in accordance with some embodiments of the present disclosure;
FIG. 16 is a flowchart of a process for estimating an energy system performance parameter for an energy storage system, in accordance with some embodiments of the present disclosure;
FIG. 17 illustrates a computing platform that may incorporate an adaptive cell model to provide energy system performance information, in accordance with some embodiments of the present disclosure;
FIG. 18 illustrates components of a cloud-computing architecture for generating and/or updating one or more reference battery models, in accordance with some embodiments of the present disclosure;
FIG. 19 illustrates a workflow for generating synthetic battery data using equivalent cycle forecasting, in accordance with some embodiments of the present disclosure;
FIG. 20 illustrates a workflow for generating trained machine learning models for estimating energy system performance properties, in accordance with some embodiments of the present disclosure;
FIG. 21 illustrates a workflow for performing one or more battery system prognostics, in accordance with some embodiments of the present disclosure;
FIG. 22 illustrates a workflow for performing analytical analysis of one or more machine learning models, in accordance with some embodiments of the present disclosure;
FIG. 23 illustrates a workflow for providing a vehicle battery management system (BMS) with an updated battery performance parameter estimation model, in accordance with some embodiments of the present disclosure;
FIG. 24 illustrates examples of pseudo-two-dimensional SOX modeling intermediate outputs, in accordance with some embodiments of the present disclosure; and
FIG. 25 illustrates example plots showing maximum discharge capacity for an SOH analysis using an OCV+2RC model, in accordance with some embodiments of the present disclosure.

### DETAILED DESCRIPTION

As described above, information about the current state of an energy storage system (e.g., a battery) in an battery-powered vehicle, such as the system's SOH, SOC, and/or SOP (collectively referred to herein as "SOX") is not directly measurable without destroying the battery. Accordingly, such quantities are typically estimated based on a model that estimates how characteristics of the energy storage system are expected to change over time as the energy storage system is used. For example, Coulomb counting uses analytical methods to statistically guess the future state of the battery or train neural networks to act as state estimators based on the response of the battery (e.g., the active flowing current). Although retrained static neural networks have shown to be more accurate than the other methods, their accuracy is limited due, in part, based on the selection of a single neural network architecture to describe the entire lifecycle of a battery. The inventors have recognized and appreciated that existing techniques, such as Coulomb counting, may provide a rough estimate of performance properties of the energy system, such techniques rely on a static model of the energy storage system, do not take into account physical characteristics of the energy system (e.g., degradation mechanisms), and are not specific to particular energy system chemistries. As such, some conventional techniques for estimating energy system performance properties may not be of sufficient accuracy to effectively optimize control strategies for electric vehicles that incorporate the energy systems. Additionally, some existing techniques are not designed to detect anomalous behavior that may result in catastrophic failures of the energy storage system in the near future. To this end, some embodiments of the present disclosure relate to use of adaptive models that include tailored empirical and/or physics-based models combined with machine learning models to provide more accurate estimation of energy system performance properties.

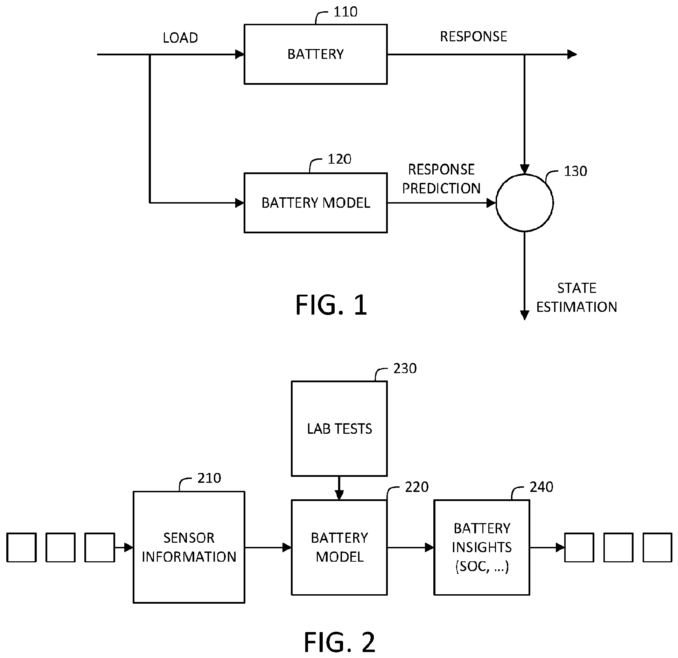

FIG. 1 schematically illustrates an adaptive cell model, in accordance with some embodiments of the present disclosure. As discussed above, in some conventional battery performance estimation techniques based on Coulomb counting, the response of the battery is used to estimate the battery performance properties, such as the battery's SOC. By contrast, an adaptive cell model configured in accordance with some embodiments of the present disclosure considers both the response of battery and a response prediction for one or more particular performance properties (e.g., SOC, SOH) output from a parameterized or "tailored" battery model to provide a state estimation of energy storage system performance. An example of such an adaptive cell model is schematically illustrated in FIG. 1. As shown in FIG. 1, load parameter values (e.g., current, voltage, ambient temperature, etc., as measured by one or more sensors and/or derived from one or more sensor measurements) are provided as input to battery system 110 to determine a response of the battery system under the current set of load conditions. The same load parameter values may be provided as input to a battery model 120 (also referred to herein as an "energy storage model"), configured to determine a response prediction and/or a property used to track cell degradation or detect battery failures. The response prediction output from the battery model 120 and the response measured from the battery system 110 may be combined at node 130 to provide a state estimation for a battery performance property with improved accuracy and/or anticipation compared to conventional techniques that, for example, use only the response measured from the battery system 110 to estimate system performance properties. In some embodiments of the present disclosure discussed in more detail below, the measured response output from battery system 110 and the response prediction output from battery model 120 may be combined at node 130 using one or more trained machine learning models (e.g., neural networks).

Throughout the lifespan of the battery system 110, the battery model 120 may be updated to more accurately reflect the current state of the battery (e.g., properties that describe the internal state of the battery, such as concentration of lithium ions in the electrodes of the battery at the current time) including effects due to degradation. Updating the battery model 120 may be performed in any suitable way. For example, the parameterization of the battery model 120 may be updated with new parameters based on current information about the state of the battery (e.g., degradation parameters). Additionally or alternatively, battery model 120 may be updated by substituting a different type of battery model 120 throughout the lifespan of the battery system 110. As described in more detail below, battery model 120 may include an empirical model, a physics-based model, or a combination of empirical and physics-based models. Examples of different types of battery model architectures for battery model 120 are also described in more detail below.

In some embodiments of the present disclosure, the manner in which the response output from battery system 110 and the response prediction output from battery model 120 are combined at node 130 may also be updated throughout the lifespan of the battery system 110. For example, when a neural network is used at node 130 to combine the response and response prediction information, the neural network parameters (e.g., weights) and/or architecture may be updated based, at least in part, on an evaluation of network architectures to accurately predict state estimations for the current state of battery system 110, information associated with other battery powered devices that include the same or a similar type of energy storage system as battery system 110, or any other suitable information.

FIG. 2 schematically illustrates that an adaptive cell model, including a parameterized battery model 220, may be incorporated into a battery management system (BMS) and/or control system (e.g., electronic control unit (ECU), vehicle control unit (VCU), etc.). For instance the estimated battery insights 240 output from the battery model 220 in response to sensor information 210 provided as input to the battery model 220, may be used by a BMS of an electric vehicle to optimize one or more aspects (e.g., charging, discharging, failure analysis, etc.) of the energy storage system in the vehicle. As shown in FIG. 2, the battery model 220 may be tailored for a particular battery chemistry by performing a plurality of laboratory tests 230 that determine physical characteristics of the battery used to parameterize the battery model 220. As discussed above in connection with FIG. 1, throughout the lifespan of the battery, the battery model 220 may be updated to more accurately reflect the current state of the battery.

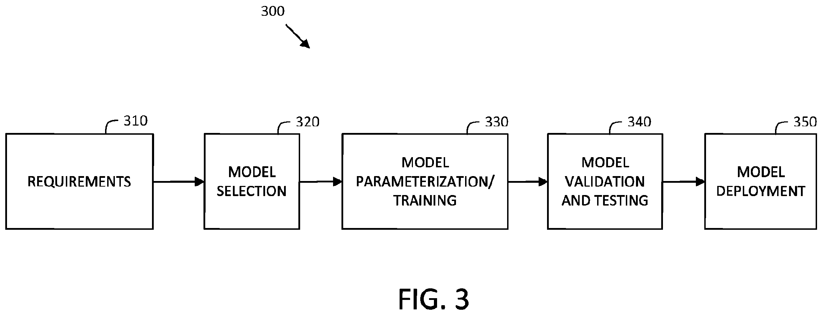

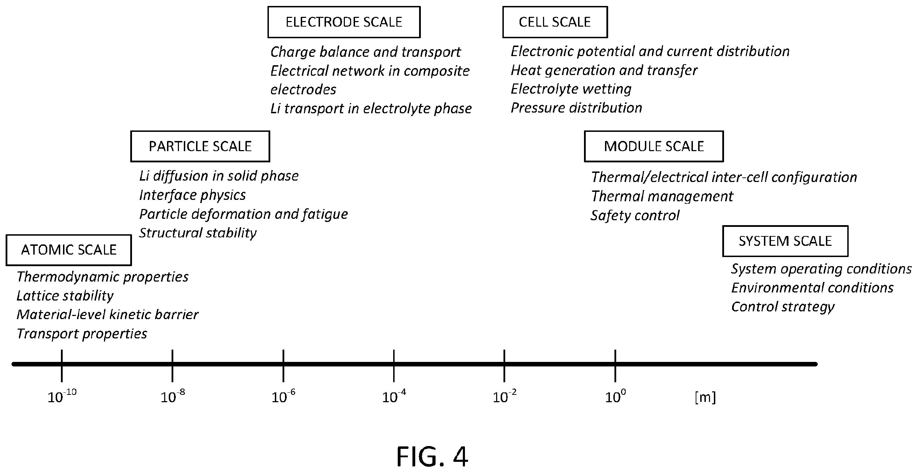

FIG. 3 schematically illustrates a flowchart of a process 300 for generating an energy storage (e.g., battery) model in accordance with some embodiments. Process 300 begins in act 320, where an appropriate model is selected based on the particular requirements 310 for an energy storage modelling implementation. FIG. 4 illustrates different classes of processes, materials, components and systems that may accounted for in an energy storage model in accordance with some embodiments of the present disclosure, though it should be appreciated that other types of energy storage models not shown in FIG. 4 may alternatively be used. The particular model to use may be selected in act 320 in any suitable way based on the implementation requirements. For instance, if the primary aim of the energy storage modelling is to develop a new battery chemistry, using a model considering the atomic or particle scale may be desired, since such models take into consideration fine physical details about the energy system that may be important to understand degradation and other processes involved in the battery research and development process. As another example, if the primary purpose of the energy storage modeling is to estimate battery performance properties for use by a BMS and/or vehicle control system, a cell scale energy storage model (e.g., including two electrodes, a separator, and an electrolyte) may be used.

In some embodiments, knowledge obtained by the study, modelling, etc. for one battery and/or chemistry may be used in act 320 to select and/or generate an appropriate model for a particular energy storage modelling implementation. For instance, a model trained to predict battery performance properties for a first type of battery/chemistry may be repurposed or reused as a starting point model for predicting battery performance properties for a second type of battery/chemistry. The model can then be further trained to improve predictions for the second type of battery/chemistry based on training data specific to the second type of battery/chemistry (e.g., as discussed in further detail below). In another example, transfer learning techniques for machine learning may be used to repurpose previous knowledge. As such, elements of a pre-trained machine learning model may be reused in a new machine learning model to reduce the resources and amount of labeled data needed to train the new machine learning model. In yet a further example, a combination of transfer learning techniques for machine learning models and reuse of a particular trained battery model as a starting point may be used. Other approaches are also possible, and the techniques described above are provided for illustrative purposes only.

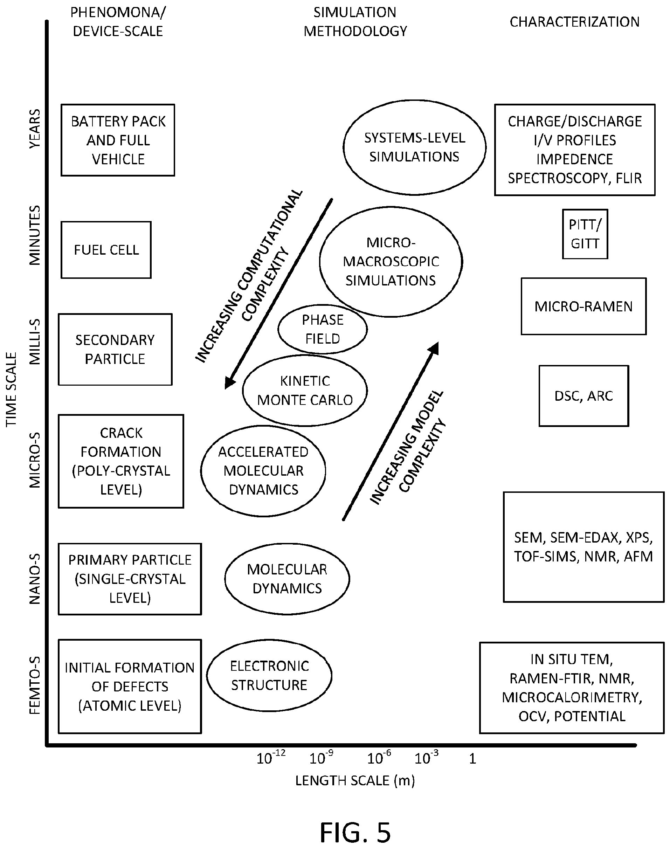

Returning to the process shown in FIG. 3, following model selection in act 320, process 300 proceeds to act 330, where the selected model is parameterized or trained based on the measurements from a plurality of lab tests, as described above. FIG. 5 illustrates various types of lab tests that may be used to inform the construction and/or parameterization of different types of (partial) models for different classes of processes, materials, components and systems for energy storage. Model parameterization for particular types of models is described in more detail below. It should be appreciated that model selection in act 320 may, in some instances, be driven by the types of lab tests available to parameterize a given model in act 330. For instance, if a detailed characterization of atomistic processes is not available for parameterization in act 330, models in the cell or system class scale may be selected in act 320. Alternatively, if measurement techniques such as scanning electron microscopy (SEM) and atomic force microscopy (AFM) are available for parameterization in act 330, models considering the particle class scale may be selected in act 320. Returning to the process shown in FIG. 3, after the selected model has been parameterized in act 330, process 300 proceeds to act 340, where the model may be validated and tested. Process 300 may then proceed to act 350, where the validated and tested model is deployed.

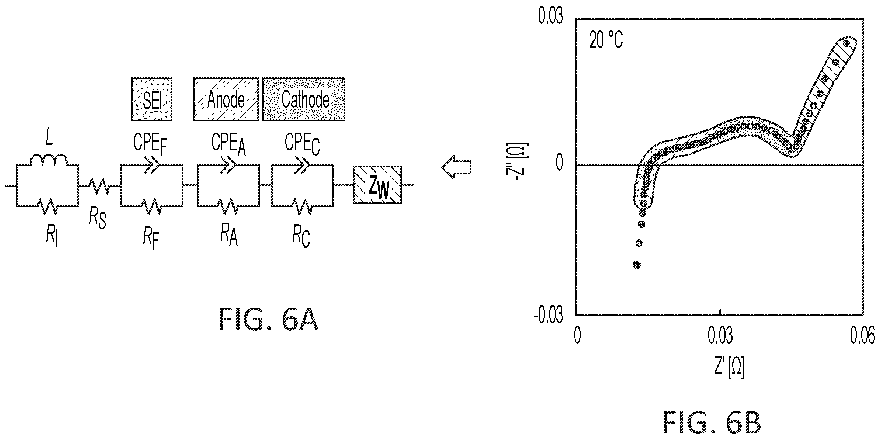

In some embodiments, the selected energy storage model may be an empirical model, a physics-based model or a combination of empirical and physics-based models. FIG. 6A illustrates an equivalent circuit model (ECM) as a non-limiting example of an empirical model that may be used in accordance with some embodiments of the present disclosure. As shown in FIG. 6A, a battery may be represented by an equivalent circuit with resistors, inductors, and capacitors that characterize various physical aspects of the battery. FIG. 6B illustrates an example of how at least some of the component values in the equivalent circuit of FIG. 6A can be determined using laboratory test measurements from a particular battery type, as described above in connection with FIG. 2. In this way, a generalized ECM may be parameterized or tailored for a particular battery chemistry of interest based on information from the laboratory test measurements.

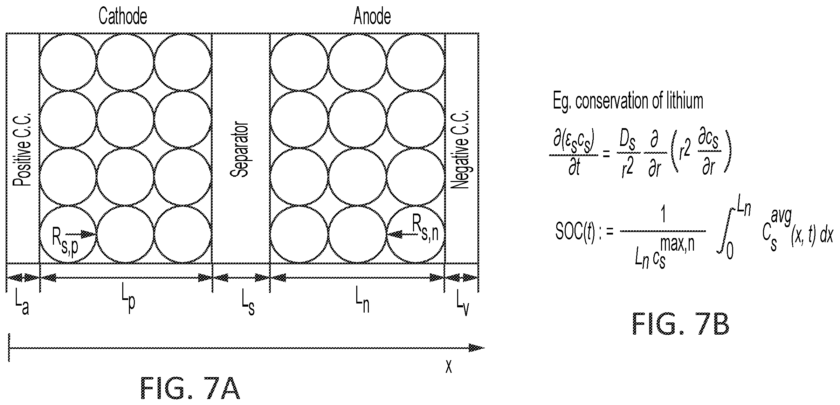

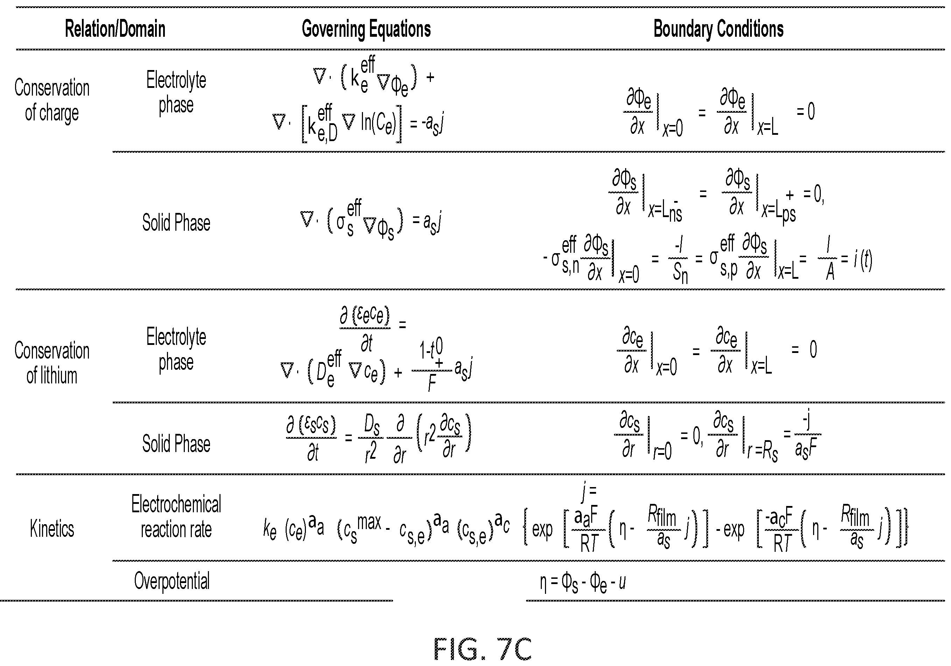

FIG. 7A schematically illustrates a non-limiting example of a physics-based model (PBM) for a battery that may be used in accordance with some embodiments of the present disclosure. As shown, the PBM includes two electrodes (a cathode and an anode), a separator and an electrolyte. FIG. 7B shows that one or more mathematical equations (e.g., an equation for conservation of lithium) can be used to describe physical aspects of the battery (e.g., internal properties of the battery) for a PBM. Additional mathematical equations may be included in the PBM to determine one or more derived energy storage performance properties of interest (e.g., state of charge (SOC), state of health (SOH)). FIG. 7C illustrates non-limiting examples of mathematical equations that may be included in a PBM to describe physical aspects of a battery. For example, mathematical equations that govern conservation of charge, conservation of lithium ions, and kinetics of the battery may be included in a generalized PBM for a battery.

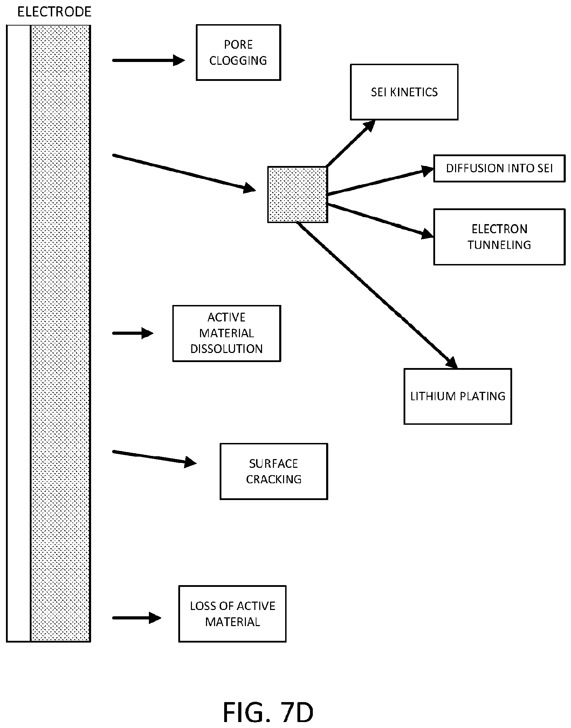

The inventors have recognized and appreciated that use of a PBM as a battery model provides a flexible approach that enables modeling essentially any type of battery chemistry, once the mathematical equations governing the battery chemistry are known and the energy storage performance properties for interest are defined. For instance, a generalized PBM that includes only mathematical equations, such as those shown in FIG. 7C, may be updated for a particular battery chemistry by adding additional mathematical equations to the model that describe physical relations of interest. Non-limiting examples of such physical relations that relate to degradation mechanisms in batteries are illustrated and described in FIG. 7D. By adding or removing equations from the set of equations included in the PBM (e.g., as the battery ages), the PBM can be customized for a particular battery chemistry and/or to estimate particular energy system performance properties of interest given a current state of the battery.

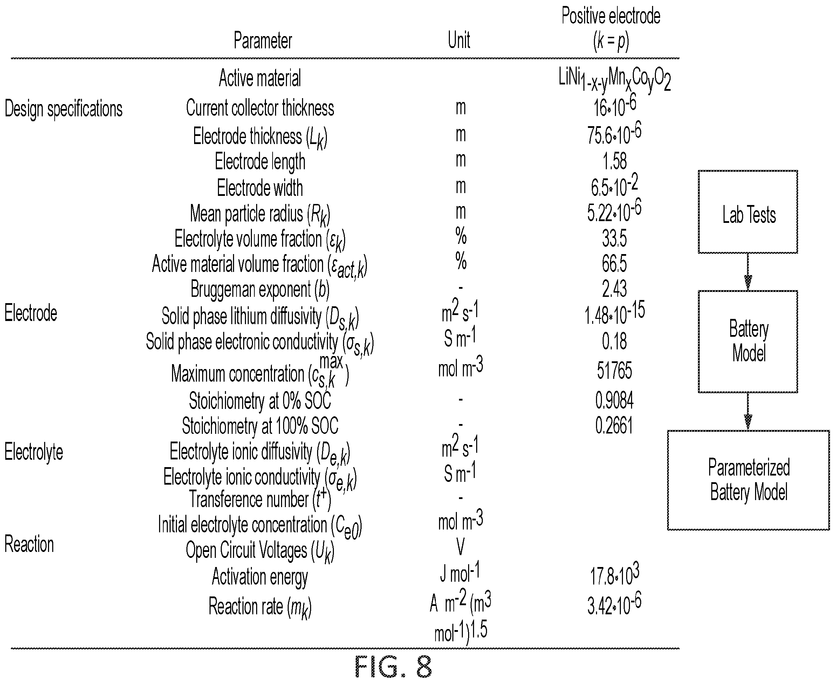

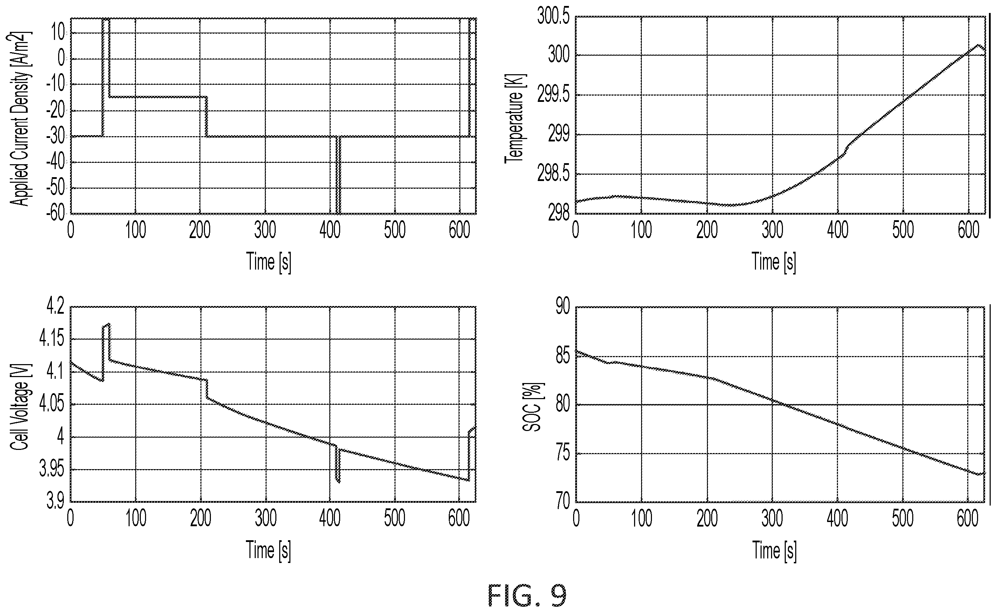

As discussed above in connection with FIGS. 2 and 3, after the PBM is selected (in this case, the set of mathematical equations for the PBM have been defined), the PBM may be parameterized by performing laboratory test measurements (or alternatively, receiving the information from other sources such as battery technical specification documents) to determine the values of the coefficients for the equations included in the PBM. FIG. 8 illustrates an example of determined coefficients for equations in a PBM associated with a design specification, electrode and electrolyte behavior, and other reaction-related properties. After determining the coefficients for the equations in the PBM to generate a parameterized PBM, the set of equations may be solved to calculate the energy system internal state and one or more derived energy system performance properties of interest (e.g., SOC) for the battery. For example, FIG. 9 graphically shows the calculation of various energy system performance properties using a parameterized PBM.

As described above, some conventional approaches for estimating energy system performance properties are based on a static model of the energy system (e.g., a battery cell), and a response measured from the output of the battery in response to a particular load. The inventors have recognized and appreciated that estimation of energy system performance properties can be improved by combining the response measured from the battery with a response prediction output from a dynamic model of the energy system implemented using empirical models, physics-based models, or a combination of empirical and physics-based models (collectively referred to herein as "energy storage models" or "battery models"), as described herein.

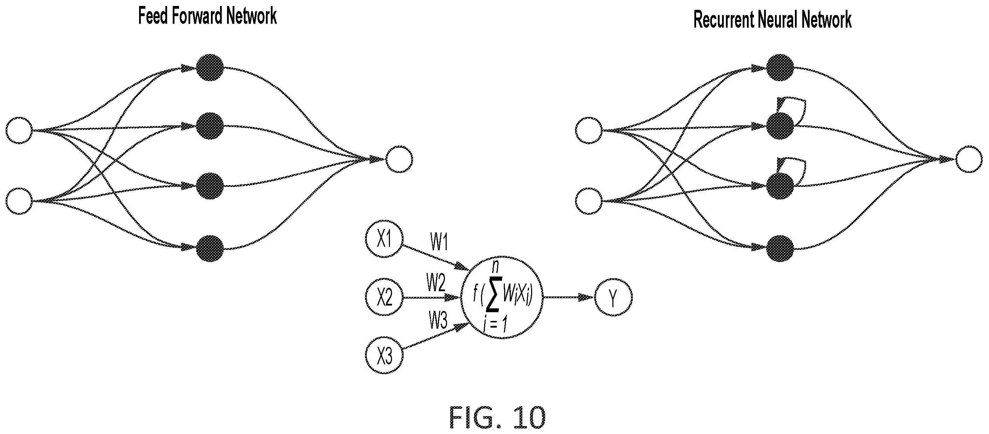

In some embodiments of the present disclosure, the measured energy storage system response and the predicted energy storage system response may be combined using a machine learning model (MLM), examples of which are schematically illustrated in FIG. 10. For instance, MLMs that may be used in accordance with some embodiments of the present disclosure include, but are not limited to, feedforward neural networks, recurrent neural networks, or a combination of feedforward and recurrent neural networks. Non-liming examples of The MLM may receive one or more inputs corresponding to the response from the battery and one or more inputs corresponding to response predictions output from the battery model. The MLM may be trained to output a state estimation for one or more battery system performance properties that takes into account the dynamic properties of the battery as it ages over time.

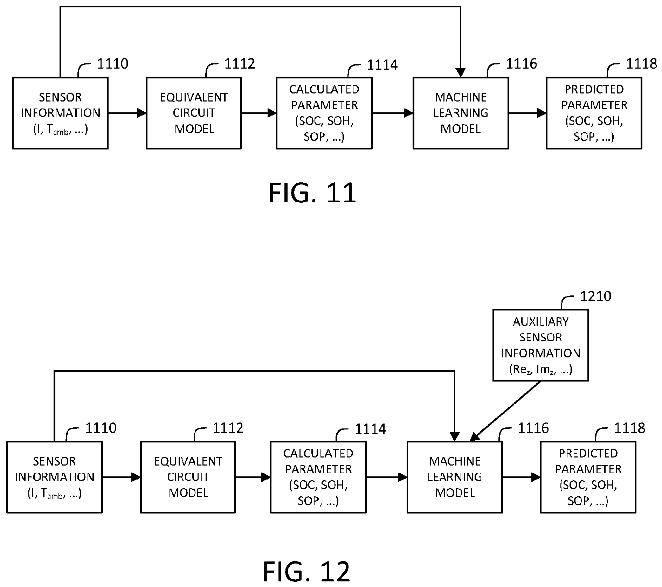

After selecting and parameterizing a battery model for a particular implementation, a workflow for an adaptive cell model including both the parameterized battery model and a trained machine learning model may be defined. FIGS. 11-15 schematically illustrate examples of workflows for adaptive cell models that may be used in accordance with some embodiments of the present disclosure.

FIG. 11 shows an example of an adaptive cell model that includes an equivalent circuit model (ECM) 1112 as the battery model. As shown in FIG. 11, sensor information (e.g., current (I), voltage (V), ambient temperature (T_{amb})) 1110 is provided as input to the ECM 1112, which may be configured to output calculated values 1114 for one or more energy system performance parameters (e.g., a voltage that represents state of charge (SOC)). It should be appreciated that sensor information 1110 may be provided directly from a sensor (e.g., unprocessed sensor data) or may correspond to processed sensor data that is derived from a sensor output. The calculated value(s) 1114 output from the ECM 1112 may then be provided as input to a machine learning model (MLM) 1116, which also receives as input the sensor information 1110 provided as input to the ECM 1112. For instance, the MLM 1116 may be implemented as a recurrent neural network (RNN). Non-limiting examples of RNNs include bidirectional recurrent neural networks, (BRNNs), long short-term memory (LSTM) networks, and gated recurrent units (GRUs). The output of the MLM 1116 may be a predicted value 1118 for one or more energy storage parameters. FIG. 12 shows another example of an adaptive cell model in which the MLM 1116 also receives additional sensor information 1210 that are not provided as input to the ECM 1110. Other configurations are also possible.

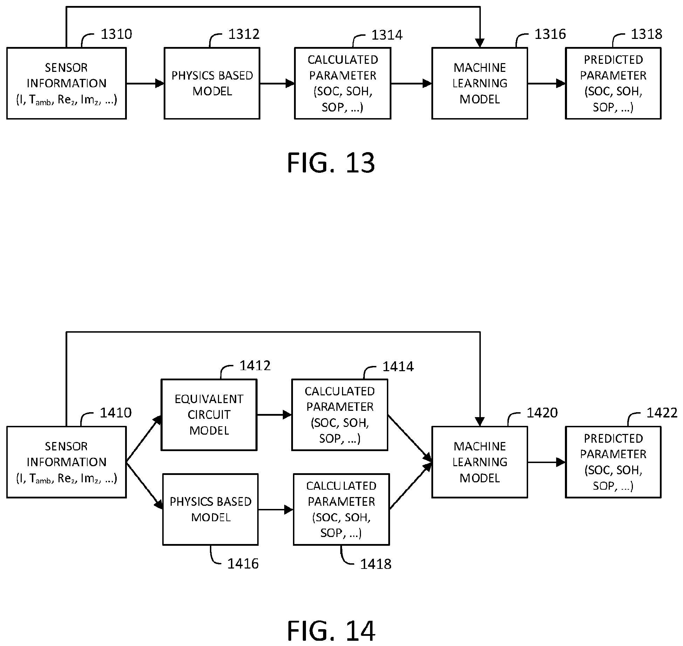

FIG. 13 shows an example of an adaptive cell model that includes a physics-based model (PBM) 1312 as the battery model. As shown in FIG. 13, sensor information (e.g., current (I), voltage (V), ambient temperature (T_{amb})) 1310 is provided as input to the PBM 1312, which may be configured to output calculated values 1314 for one or more energy system performance parameters (e.g., a voltage that represents state of charge (SOC)). It should be appreciated that sensor information 1310 may be provided directly from a sensor (e.g., unprocessed sensor data) or may correspond to processed sensor data that is derived from a sensor output. The calculated value(s) 1314 output from the PBM 1312 may then be provided as input to a machine learning model (MLM) 1316, which also receives as input the sensor information 1310 provided as input to the PBM 1312. The output of the MLM 1316 may be a predicted value 1318 for one or more energy storage parameters.

FIG. 14 shows an example of an adaptive cell model that includes both an equivalent circuit model (ECM) 1412 and a physics-based model (PBM) 1416, which collectively form the battery model. As shown in FIG. 14, sensor information (e.g., current (I), voltage (V), ambient temperature (T_{amb})) 1410 is provided as input to each of the ECM 1412 and PBM 1416. It should be appreciated that sensor information 1410 may be provided directly from a sensor (e.g., unprocessed sensor data) or may correspond to processed sensor data that is derived from a sensor output. The ECM 1412 may be configured to output first calculated values 1414 for one or more energy storage performance parameters, and the PBM 1416 may be configured to output second calculated values 1418 for one or more energy system performance parameters. The first calculated value(s) 1414 output from the ECM 1412 and the second calculated values 1418 output from the PBM 1416 may then be provided as input to a machine learning model (MLM) 1420, which also receives as input the sensor information 1410 provided as input to the ECM 1412 and PBM 1416. The output of the MLM 1420 may be a predicted value 1422 for one or more energy storage parameters.

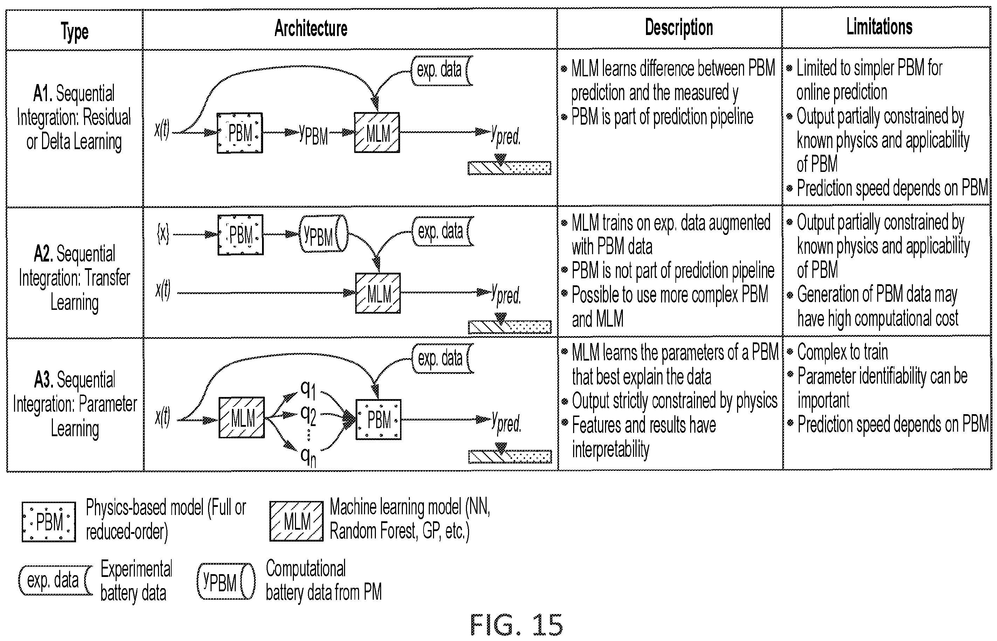

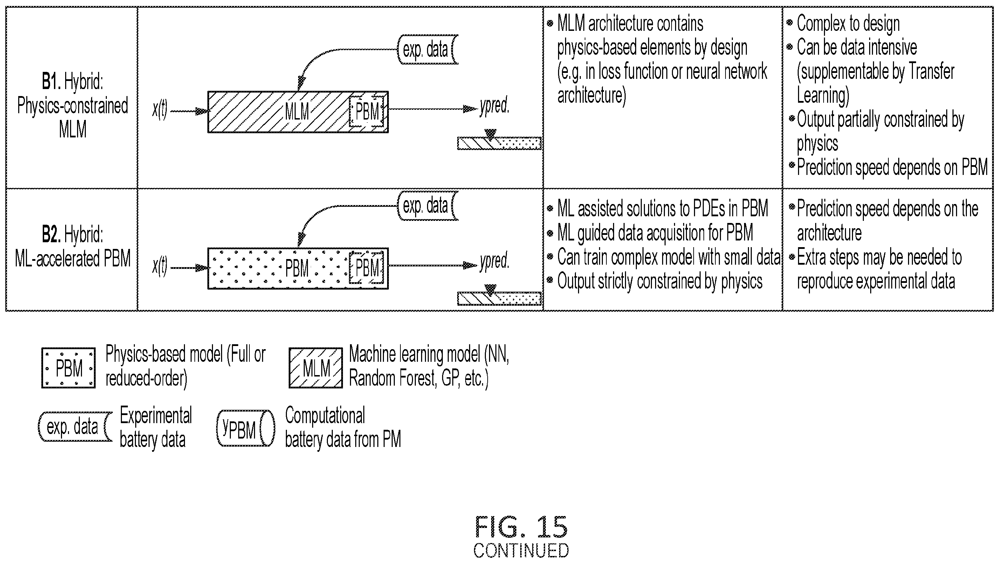

Although not shown in FIGS. 13 and 14, it should be appreciated that the machine learning model in the adaptive cell model may be configured to receive additional sensor information not provided as input to the corresponding battery model, as shown in the example of FIG. 12. In some embodiments of the present disclosure, the workflow for the adaptive cell model that is selected for a particular implementation may be determined based on the requirements for the implementation. In addition to the example adaptive cell model workflows shown in FIGS. 11-14, other non-limiting examples of adaptive cell model workflows that may be used in accordance with some embodiments of the present disclosure are shown in FIG. 15. It should be appreciated that selection of a suitable workflow according to the requirements of a particular implementation provides for a substantial amount of flexibility in generating appropriate adaptive cell models for estimation of energy system performance properties across a wide range of energy storage systems.

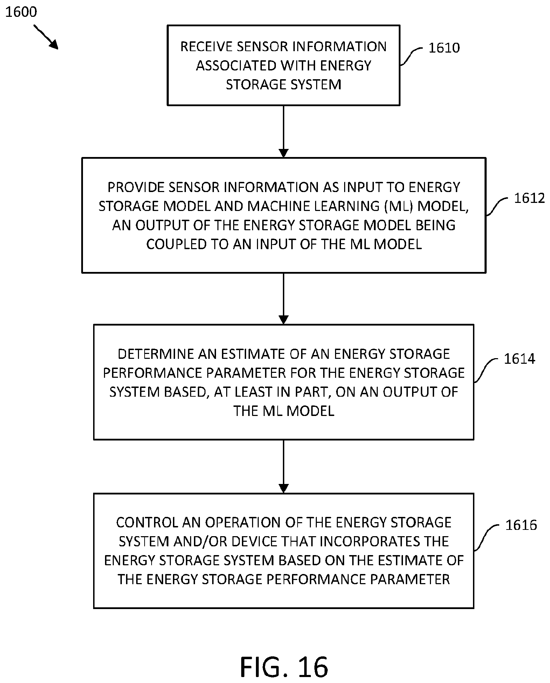

FIG. 16 is a flowchart of a process 1600 for controlling an operation of an energy storage system, in accordance with some embodiments of the present disclosure. In act 1610, sensor information is received from one or more sensors associated with an energy storage system. For instance, when the energy storage system is a battery system incorporated in an electric vehicle, the sensor values(s) may correspond to values for one or more of a voltage, a current, a temperature, or a pressure associated with the battery system. It should be appreciated that the sensor information may include values measured directly by a sensor of the battery system and/or values derived from one or more sensor measurement. Process 1600 then proceeds to act 1612, where the received sensor information is provided as input to an energy storage model (e.g., a physics-based model, an empirical model, or a combination of physics-based and empirical models). An output of the energy storage model may be coupled to a machine learning model trained to output a state estimation for one or more energy system performance parameters. In act 1612, the sensor values provided as input to the energy storage model may also be provided as input to the machine learning model. Process 1600 then proceeds to act 1614, where an estimate of an energy storage performance parameter (e.g., SOH, SOC, SOP) is determined based, at least in part, on an output of the machine learning model. In some embodiments, the machine learning model may be trained to output the estimate of the energy storage performance parameter directly. In other embodiments, an output of the machine learning model may be processed further by one or more computer processors, and the estimate of the energy storage performance parameter may be determined based on processed result.

Process 1600 then proceeds to act 1616, where an operation of the energy storage system and/or a device that incorporates the energy storage system is controlled based, at least in part, on the estimate of the energy storage performance parameter. For example, in some embodiments, the estimate of the energy storage performance parameter may be used to update one or more battery metrics displayed on a user interface of an electric vehicle. In other embodiments, the estimate of the energy storage performance parameter may be used to control a charging/discharging operation of the energy storage system. In yet further embodiments, the estimate of the energy storage performance parameter may be used to control a safety system of an electric vehicle to facilitate avoidance of a catastrophic failure of the energy storage system. It should be appreciated that the estimate of the energy storage performance parameter may be used in any other suitable way.

In some embodiments of the present disclosure, a parameterized battery model (e.g., ECM, PBM, or combination of ECM and PBM), a trained machine learning model, and the corresponding workflow for the adaptive cell model may be incorporated into a computing platform that enables the predicted energy system performance parameters to be used in practice (e.g., as part of a BMS in an electric vehicle). BMS computing architectures often have limited memory and/or compute resources available to dynamically update one or more aspects of the adaptive cell model. To this end, some embodiments of the present disclosure may be implemented using a distributed architecture. In the distributed architecture, a local (e.g., compiled) battery model may be stored on the BMS, and one or more digital twins, each representing one or more physical battery cells of the electric vehicle, may be implemented using a network-connected compute architecture (e.g., a cloud-computing platform). Sensor values measured by one or more sensors of the electric vehicle may be provided to the cloud-computing platform (e.g., via an Internet of Things (IoT) gateway) to update the digital twin(s). The updated digital twins may be used to generate an updated battery model, which may be used to update the local battery model stored on the BMS. In this way, both the local battery model and the digital twins implemented using the cloud-computing platform may be dynamically updated to provide more accurate estimates of energy system performance properties (e.g., SOC, SOH, SOP).

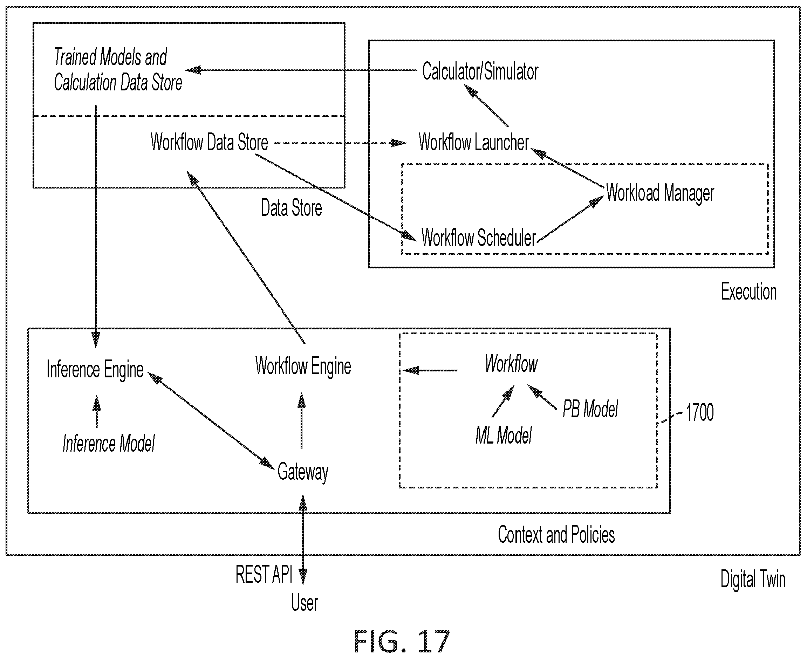

FIG. 17 schematically illustrates an example cloud computing platform that incorporates an adaptive cell model 1700 in accordance with some embodiments of the present disclosure. In particular, FIG. 17 shows a system for using digital twins for scalable and adaptive model-based battery management comprising one or more digital twins and a cloud computing platform.

The digital twins may correspond to physical battery cells. Each digital twin may include one or more inference engines, workflow engines, and databases. Each inference engine may be configured with one or more inference models configured to process sensor information for battery prognostics, and request calculations as needed to improve estimations. Each workflow engine may be configured with one or more computational workflows relying on customized inference models and/or battery cell models capable of predicting the internal state and performance of the physical battery, and store calculation outputs. The inference engines, workflow engines, and databases may share computing resources or reside on separate computing resources that communicate via cloud connectivity. Digital twins may share inference engines, workflow engines or computational workflows and models, and databases. As described herein, battery cell models can be physics-based (corresponding to a set of mathematical equations; e.g., pseudo-two-dimensional models), empirical models, (e.g., equivalent circuit models), or combinations. Inference models may be data-driven models (e.g., machine learning models such as recurrent neural networks).

An example of using the system of digital twins shown in FIG. 17 may be as follows. A user of the computing platform (or alternatively, a BMS of an electric vehicle) may query the system for internal state and/or performance information about a battery cell for a given load profile. Such a query may correspond to a question that can be thought of in the form: "what is the expected state of charge for a specified battery and current profile?" The system may respond with the requested information. In this example, the predictions may require prior calculation and/or processing and analysis of such properties as current, voltage, temperature, and state of charge profiles. If these calculations have not been already performed, the system may proceed to execute a set of predefined workflows for battery cell calculations and add the results to the knowledge base. In the example shown in FIG. 17, the calculations involved include setting up and solving a physics-based model for battery cells.

Some conventional systems that use machine learning models for predicting battery usage characteristics have limited learnings to the model. Some embodiments of the present disclosure include multiple components (e.g., multiple learning systems) to facilitate learning for SOH, SOC and SOP estimation. The multiple components may work together to optimize the understanding of and modeling of the battery. In addition, some embodiments include a learning component configured to detect anomalous behavior of batteries, which may be important, for example, for high energy density batteries that may have catastrophic failures that the anomaly detector can prevent by early warning.

Additionally, some electric vehicle battery management systems (BMS) that use machine learning (ML) to estimate battery characteristics are relatively static and learn only from the on-vehicle battery. Due to the limited dataset on which the ML model is trained, such ML models typically are unable to accurately predict outcomes when faced with unexpected conditions (e.g., conditions that it has not learned from). Some embodiments of the present disclosure are configured to continuously learn from multiple batteries, and then apply that knowledge to a particular battery. By retraining an ML battery model for a particular battery based on learnings that happen to other batteries, the state estimations output from the ML battery model may become more accurate and the model may be able to deal with a wider range of possible input conditions.

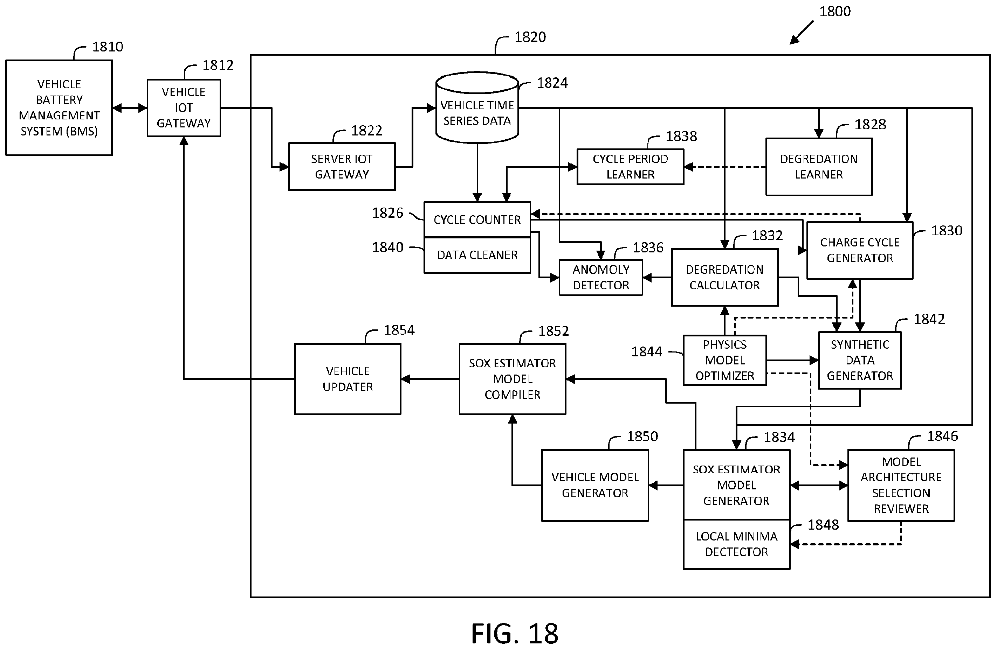

FIG. 18 illustrates a distributed architecture 1800 that includes components configured to implement one or more adaptive cell models, in accordance with some embodiments of the present disclosure. Distributed architecture 1800 includes a vehicle battery management system (BMS) 1810 on which a local battery model used to predict battery performance parameters (e.g., SOH, SOC, SOP) may be stored. Sensor values from the vehicle incorporating the BMS 1810 may be provided as input to cloud-computing platform 1820 via vehicle IoT gateway 1812 and server IoT gateway 1822. Although the example distributed architecture 1800 in FIG. 18 shows sensor values from the BMS being provided via an IoT gateway, it should be appreciated that the sensor values may be provided to cloud-computing platform 1820 in any suitable way.

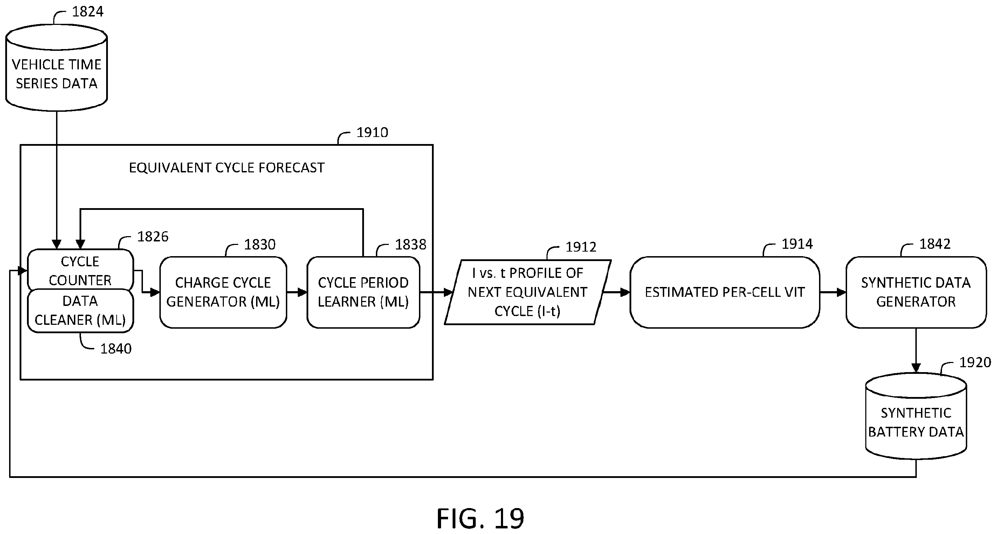

Sensor values received by cloud-computing platform 180 may be stored in vehicle time-series datastore 1824. For instance, vehicle time-series datastore 1824 may be configured to store time-series information associated with one or more of the BMS state of charge, current values, voltage values, temperature values, and/or pressure values associated with the physical energy storage system. As described above, the values stored in time-series datastore 1824 may be provided as input to one or more adaptive cell model architectures used to estimate energy storage system parameter(s), collectively SOX. As shown in FIG. 18, one or more of the values in vehicle time-series datastore 1824 may be provided as input to various machine learning processes, described in more detail below. FIG. 18 illustrates an overview of various components of an example cloud-computing platform used in accordance with some embodiments. FIGS. 19- 23 describe subsets of these components (and in some cases other components) that may be configured to implement one or more workflows, in accordance with some embodiments.

Some embodiments of the present disclosure are configured to monitor not only a specific battery but multiple (e.g., all) batteries of the same type (e.g., in the same vehicle make and model). In one aspect, the history of change in the model architecture and/or coefficients (e.g., using Genetic Algorithms, Monte Carlo methods, or linear selection) may be used to determine if changes to the architecture and/or coefficients are warranted or if the changes are too significant and therefore, should not be adopted. The cycle period may then be adjusted in a control systems way (e.g., using a Nyquist Stability Criterion) to optimize the period. In some embodiments, the variable tracked from Charge/Discharge cycles may be changed to Time or simply to the number of reported data points if needed. The techniques for charge cycle generation may be compared to determine which one or combination of methods provides the best stability (e.g., based on the stability of the SOX estimator) and/or the Local Minima detector results, described in more detail below.

In one aspect, the values stored in the vehicle time-series datastore 1824 may be provided as input to an equivalent cycle forecast workflow 1910 as shown in FIG. 19. The equivalent cycle forecast workflow 1910 may include cycle counter 1826, charge cycle generator model 1830, cycle period learner model 1838 and a data cleaner model 1840. The output of the equivalent cycle forecast workflow 1910 may be used to generate synthetic battery data 1920.

An initial step in a control system may be to understand the necessary cycle period. For example, it may be important to catch events (e.g., per the Nyquist Theorem) but not to over-sample for both compute cost and identifying false artifacts in the data. If an ML model is trained too often, compute resources are unnecessarily expended and the model may potentially be forced to drive to a local minima or to oscillate more quickly, which may make the model ineffective. Some embodiments of the present disclosure include a cycle period learner model 1838 trained to determine a rate at which updates to the SOX estimator model should occur.

In the example equivalent cycle forecast workflow 1910 shown in FIG. 19, the vehicle time-series data 1824 is provided as input to cycle counter 1826, which may be configured to determine a period of a charge cycle (e.g., a number of days in a charge cycle) based on the vehicle time-series data 1824. Output of the cycle counter 1826 may be provided as input to charge cycle generator model 1830, which may be configured to determine the most likely charge/discharge cycle generation used to predict future battery experiences.

Creating a prediction for a future SOX estimator model may start by predicting how the vehicle will be used. In some embodiments of the present disclosure, the vehicle's prior charge/discharge cycle history may be used to predict the most likely future drive cycle. For instance, if the cycle counter 1826 determines that the average charge cycle for the vehicle is 7 days, the charge cycle generator model may be configured to model a 7-day charge cycle for the future SOX estimator model. In some embodiments, the prior history is analyzed to ignore unusual driving and charging patterns (e.g., exceptions such as going on vacation and leaving the vehicle at home, undriven, or going on a long road trip once a year) and select the best fit future cycle in a weighted selection scheme. Predicting the future drive/charge cycling may be important in order to generate a SOX estimator model that will be accurate over its planned duration.

As shown in FIG. 19, the output of the charge cycle generator model 1830 may be provided as input to cycle period learner model 1838, which as described above, may be used to determine a rate at which updates to the SOX estimator model should occur. The output of the charge cycle learner model 1838 may be fed back as input to cycle counter 1826 as shown in FIG. 19. For example, the charge cycle learner model 1830 may determine that an 8-day charge cycle rather than a 7-day charge cycle may more appropriately represent the previous usage of the vehicle, and that information may be relayed back to cycle counter 1826.

The equivalent cycle forecast workflow 1910 also includes data cleaner model 1840. The inventors have recognized and appreciated that data from vehicles is not always complete. For example, when a vehicle is driven out of cellular service range and a network connection (e.g., an IoT gateway) can no longer store data due to its limited memory capacity, data loss may occur. In some embodiments, data cleaner model 1840 employs predictive analytics based on historical data to determine what would have happened in the past to account for such missing data. In some embodiments, data may be regenerated from highly probable sources, examples of which include Global Positioning Satellite (GPS) location data or prior drive information. For instance, GPS location data with start and end locations of the missing data may be used to review prior drives in the corresponding area, or the GPS data and the elevation, traffic, and other conditions (e.g. weather) may be used to determine what the likely drive cycle in that area was likely to be.

As shown in FIG. 19, an output of the cycle period learner model 1838 may be used to determine a current vs. time (I-t) profile 1912 of the next equivalent cycle of the battery. The I-t profile 1912 may be used to determine estimated values for voltage, current and temperature (estimated per-cell VIT 1914) over the next equivalent cycle of the battery, and those estimates may be provided to synthetic data generator 1842 configured to generate synthetic battery data 1920. In some embodiments, synthetic data generator 1842 is configured to generate a reference dataset (synthetic battery data 1920) of the historical SOX for a dataset (e.g., SOC, SOH, SOP), as well as any internal properties which could support any data-driven analysis for battery lifetime, fault probability, or improved controls. Depending on data availability or data quality, different techniques may be leveraged to best characterize cell historical performance and degradation indicators for a particular battery system. In some embodiments, synthetic battery data 1920 includes data corresponding to equivalent cycles, time, voltage, current, temperature, SOC, SOH, SOP, and/or battery degradation properties including, but not limited to, active material loss and resistance growth.

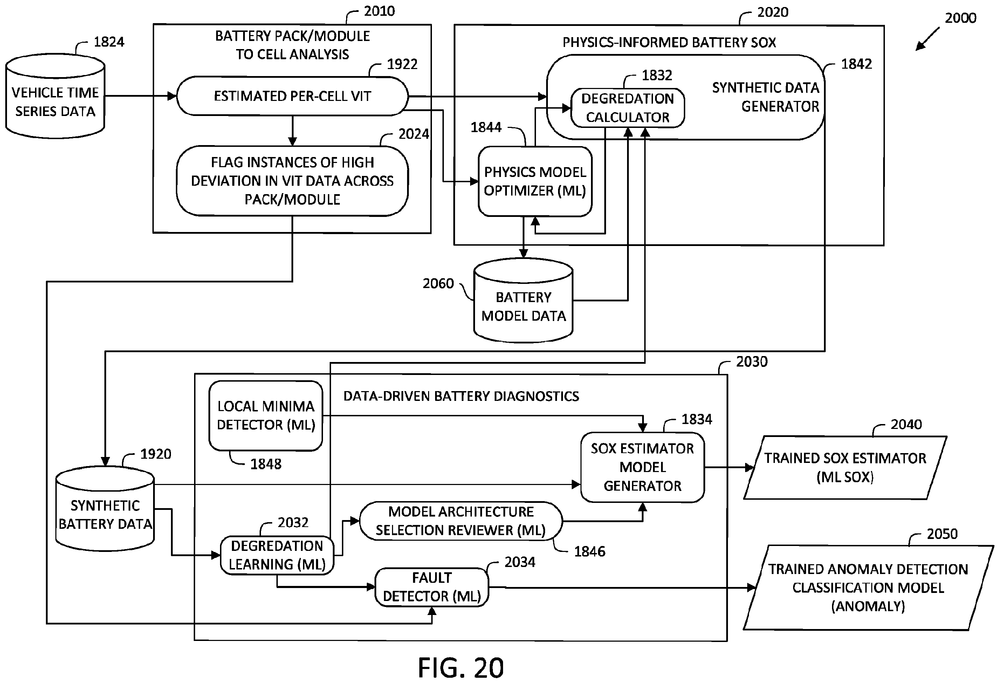

FIG. 20 illustrates a workflow 2000 for determining a trained SOX estimator (ML SOX) 2040 and a trained anomaly detection classification model (Anomaly) 2050 in accordance with some embodiments. As shown in FIG. 20, the vehicle time-series data 1824 may be provided as input to battery pack/module to cell analysis process 2010. As described above in connection with FIG. 19, the vehicle time-series data 1824 may be used to determine estimated per-cell values for voltage, current and temperature (estimated per-cell VIT 1914) based on the output of equivalent cycle forecast workflow 1910. The estimated per-cell VIT 1914 is also represented in workflow 2000 of FIG. 20. As shown in FIG. 20, the estimated per-cell VIT 1914 may be provided as input to a physics-informed battery SOX workflow 2020. Additionally, the estimated per-cell VIT data 1914 may be analyzed to flag instances of high deviations across the battery pack/module (process 2024 in FIG. 20), which may be used in the generation of the anomaly detection classification model 2050. In some embodiments, a high or "abnormal" deviation that may be flagged in any suitable way. For instance, the estimated per-cell VIT data 1914 may be associated with one or more average values and corresponding standard deviation values. An abnormal deviation may be flagged when a deviation from the average value for a particular battery characteristic is more than a multiple number of standard deviations (e.g., 1x, 2x, 3x, 4x SDs) from the corresponding average value. Abnormal deviations may be flagged based on any other suitable criteria (e.g., by comparing estimated values to threshold values), and the criteria used to flag abnormal deviations may differ across types of data.

As shown in FIG. 20, the physics-informed battery SOX workflow 2020 includes synthetic data generator 1842 and physics model optimizer model 1844. The estimated per-cell VIT values 1914 may be provided as input to each of these components. As described above, synthetic data generator 1842 may be configured to generate a reference dataset (synthetic battery data 1920) of the historical SOX for a dataset (e.g., SOC, SOH, SOP). In the physics-informed battery SOX workflow 2020, the synthetic data generation process takes into account degradation information about the battery being modeled as informed by a physics-based model. In some embodiments, physics model optimizer 1844 may be a model that employs continuous learning to tune physics-based models to better match the data received on the behavior of the batteries, not just in a particular vehicle but across multiple similar vehicles (e.g. vehicles of the same make and model). In some embodiments, an advanced model fit finder and/or optimization techniques may be used to tune the parameters of the degradation model to fit the real-world data (e.g., the data stored in the vehicle time series database 1824). As actual data from multiple vehicles is acquired over the entire lifetime of their batteries, extensive data can be collected to be used to best tune the degradation mode for greater accuracy, which in turn may impact the accuracy of the SOX estimator model 2040.

As shown in FIG. 20, synthetic data generator 1842 may be configured to generate synthetic battery data 1920 using a degradation calculator 1832 that accounts for degradation of the battery as represented in the output of the physics model optimizer 1844 and battery model data 2060. Battery model data 2060 may include, for example, information about a battery's beginning of life open circuit voltage (BOL OCV), beginning of life capacity (BOL capacity), material properties, degradation modes, available pseudo-two-dimensional (P2D) parameters, etc., that may be used to estimate degradation of a particular battery over time. Examples of different types of degradation properties/modes that may be used in accordance with some embodiments of the present disclosure are described herein.

As described herein, physics-based models, empirical models (e.g., equivalent circuit models) or a combination of physics-based and empirical models may be used to estimate degradation of a battery, in accordance with some embodiments of the present disclosure. Examples of models that may be used to evaluate degradation of a battery when generating synthetic battery data in accordance with some embodiments include, but are not limited to, pseudo-two-dimensional (P2D) models, Open Circuit Voltage + Thevenin Circuit Fit models (OCV + 2RC), and Mid-Cycle Reference Performance Test models. An example discussion of each of these types of models is provided below.

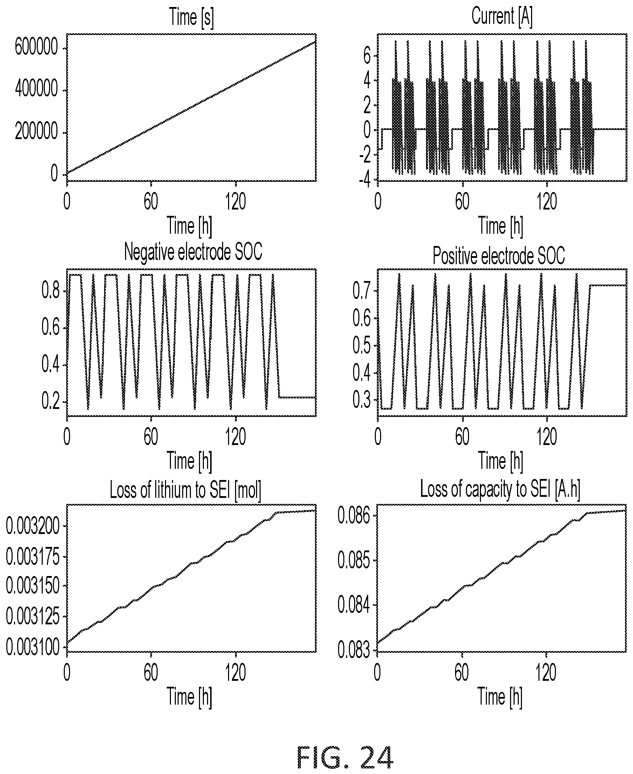

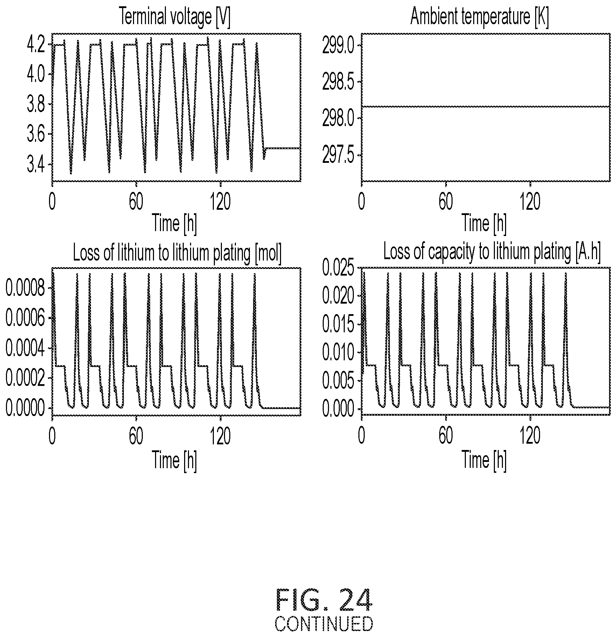

A P2D model leverages an extensive list of material properties throughout the history of a battery cell to approximate the lithium ion transport, charge kinetics, and temperature response within the cell under load. An advantage of using a P2D model is that precise monitoring of lithiation and active material changes during cycling may be used to track SOC and SOH of the battery directly, rather than estimating those properties from the accumulated capacity and voltage values. However, the detail of the P2D model may, in certain scenarios, also lead to decreases in accuracy at the end of life of the cell if there are errors in the model parameters and/or if the degradation mechanisms are unknown or poorly calibrated. FIG. 24 provides examples of P2D SOX modeling intermediate outputs in accordance with some embodiments of the present disclosure.

An OCV+2RC model leverages voltage as a primary characteristic to correlate a given charge or discharge cycle with the beginning of life (BOL) open circuit voltage (OCV) and capacity. An optimized Thevenin 2RC Circuit mathematical model may represent the voltage response of a battery. When a charge or discharge load on the cell stops, the 2RC model extracts the OCV as the cell returns to its equilibrium voltage over time. In the OCV+2RC model, OCV maps to an SOC using the BOL data, effectively giving a robust SOC datapoint every rest period, regardless of cycling condition, as long as there exists BOL OCV data at or near the intended temperature. The capacity change between rest periods can then be used to extract a continuous SOC estimation during cycling, and quantify the full discharge capacity, used for SOH estimation.

The OCV+2RC model also allows for the extraction of instantaneous resistance through Ohm's law (V=I*R) which, when paired with the OCV, can inform the SOP and SOH outputs. SOH in particular may improve by identifying both the maximum discharge capacity as limited by active material, as well as the maximum discharge capacity as limited by resistance growth under a representative applied current.

Some advantages of the OCV+2RC model include that OCV and rest period data available in the vehicle time-series data may be used to determine the SOC, and that the model works well throughout the lifecycle of the cell regardless of its load profile. Some disadvantages of using the OCV+2RC model may include that it is heavily reliant on quality OCV data and the assumption that the SOC during charge and discharge has a linear relation with capacity.

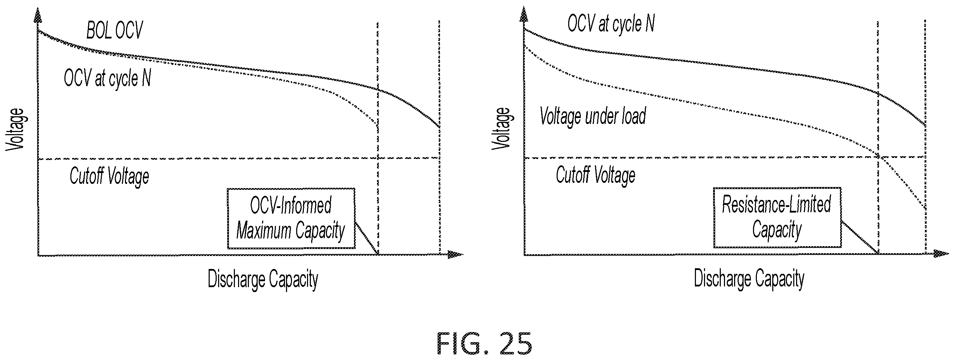

FIG. 25 illustrates example plots showing maximum discharge capacity for an SOH analysis using an OCV+2RC model. Using the information in the plots of FIG. 25, SOC may be determined directly at the start and end of a cycle, with a linear fit during the cycle as a function of capacity [Ah], and SOH may be determined as (full discharge capacity at cycle N)/ (BOL OCV full capacity).

The Reference Performance Test approach adds a recurring calibration of the maximum discharge capacity of the cell by performing a low-current CC-CV full charge of the cell followed by a low-current CC full discharge of the cell every N cycles, allowing an SOC & SOH estimation using the following equations: $\begin{matrix}SOC \left[%\right] = \frac{Available Discharge Capacity \left[Ah\right]}{Maximum Discharge Capacity of Cell \left[Ah\right]} \\ \approx 100 % - \frac{Net Capacity Discharged Since Full Charge \left[Ah\right]}{Maximum Discharge Capacity of Cell \left[Ah\right]}\end{matrix}$ $SOH \left[%\right] = \frac{Maximum Discharge Capacity of Cell \left[Ah\right]}{Maximum Discharge Capacity of Cell at BOL \left[Ah\right]}$

Which of the models may be used in a particular implementation may be based, at least in part, on the computational resources available and/or the available information to provide as input parameters to the model. For instance, although the P2D model is more detailed and may be able to represent degradation processes more accurately, it may require increased computational resources compared to the OCV+2RC model. Additionally, the input parameters for the OCV+2RC model may be more readily available from the vehicle time-series data than the information needed to determine the input parameters for the P2D model, but perhaps may not model the degradation process as accurately.

Returning to the workflow 2000 shown in FIG. 20, a particular model may be selected and parameterized using the battery model data 2060, the output of physics model optimizer 1844, and degradation calculator 1832. Synthetic battery data 1920 may then be generated by providing the estimated per-cell VIT as input to the parameterized model.

As shown in FIG. 20, the synthetic battery data 1920 may be used to determine the SOX estimator model 2040 and the anomaly detection classification model 2050 using data-driven battery diagnostics workflow 2030. For instance, synthetic battery data 1920 may be provided as input to degradation learning model 2032. As described above, physics-based models are approximations of the battery and may not account for various factors like manufacturing process variations. Even if they did, there may still be uncertainty in the results of the output of the models based on any specific charge/discharge cycling. Knowing the degradation characteristics of the battery in specific physical ways may be important to understanding the SOH of the battery, which in turn may impact the SOC and SOP determinations. In some embodiments, degradation learning model 2032 is configured to use continuous learning to tune physics-based models to better match the data received on the behavior of the batteries, not just in a particular vehicle but across multiple vehicles. In some embodiments, an advanced model fit finder and optimization techniques may be used to tune the parameters of the degradation model to fit the real-world data. In some embodiments, degradation learning model 2032 may use Genetic Algorithms and/or other model finding techniques to identify the best model for the data. As shown, an output of degradation learning model 2032 may be provided as input to degradation calculator 1832, described above.

An output of degradation learning model 2032 may also be provided to fault detector model 2034. As described previously, instances of high deviation in VIT data determined in battery pack/module to cell analysis process 2010 may also be provided as input to fault detector model 2034. Based on these inputs, a trained anomaly detection classification model 2050 may be determined. The anomaly detection classification model 2050 may learn what signals a battery provides along with the known SOH indicating anomalous behavior that could result in catastrophic failure of the battery. The inventors have recognized that high energy batteries in particular are often prone to catastrophic failures that are often undetectable by conventional SOH estimation techniques. In some embodiments of the present disclosure, anomalous behavior may be detected by using advanced algorithms to detect changes, (e.g., abnormal temperature fluctuations vs current or a pattern of slightly lower voltages against current draws or a more complex multi-factor analysis, either in short-term or long-term data) to identify an impending anomaly. By detecting impending problems with batteries, some embodiments are able to warn operators of impending problems that warrant intervention before a catastrophic event happens.

As shown in FIG. 20, an output of degradation learning model 2032 is also provided as input to model architecture selection reviewer model 1846. Some conventional battery models that employ machine learning use only one architecture of neural network, which may be trained based on a limited dataset throughout the lifetime of the battery. The inventors have recognized and appreciated that such models may provide inaccurate estimates of the battery system performance parameters (e.g., SOH, SOC, SOP), especially as the battery ages. To this end, some embodiments of the present disclosure include a model architecture selection reviewer model 1846 configured to revisit each battery and its data to check that the right model architecture, not just the right coefficients, is the best choice for the SOX estimator generation process. In some embodiments, the architecture selection reviewer model 1846 may be implemented as a superset of the SOX estimator model generator 1834, as the architecture selection reviewer model 1846 may not be time limited in its computations. In some embodiments, the architecture selection reviewer model 1846 is configured to use methodologies such as Genetic Algorithms to test each model architecture against the existing data and test fit using Akaike Information Criterion (AICc) scoring or a similar methodology for evaluating which model is best for a given data set, resulting in selection of an optimum model architecture each time an update of the model is performed, which may result in more accurate estimate of energy storage system parameters (e.g., SOH, SOC SOP) than if a single model architecture was used throughout the lifetime of the energy storage system.

As shown in FIG. 20, the trained SOX estimator model 2040 may be output from SOX estimator model generator 1834, which receives as input, output of the model architecture selection reviewer model 1846, as just described, synthetic battery data 1920 and information from local minima detector model 1848. In some embodiments, SOX estimator model generator 1834 is configured to analyze a large collection of possible neural networks, and the combined electrochemical, physics-based, analytics and neural network models may be evaluated to determine the best fit based on the available data. In some embodiments, the selection of models analyzed by SOX estimator model generator 1834 may be restricted based, at least in part, on the capabilities of an associated BMS to be able to execute the model.

Neural networks and other control models have a tendency to not understand when they are stuck in a local minima. In some embodiments, local minima detector model 1848 is configured to ensure one or more models are not trapped in non-optimal conditions, resulting in a system that provides more accurate results for energy storage system performance parameters (e.g., SOH, SOC, and SOP) over the lifetime of the battery.

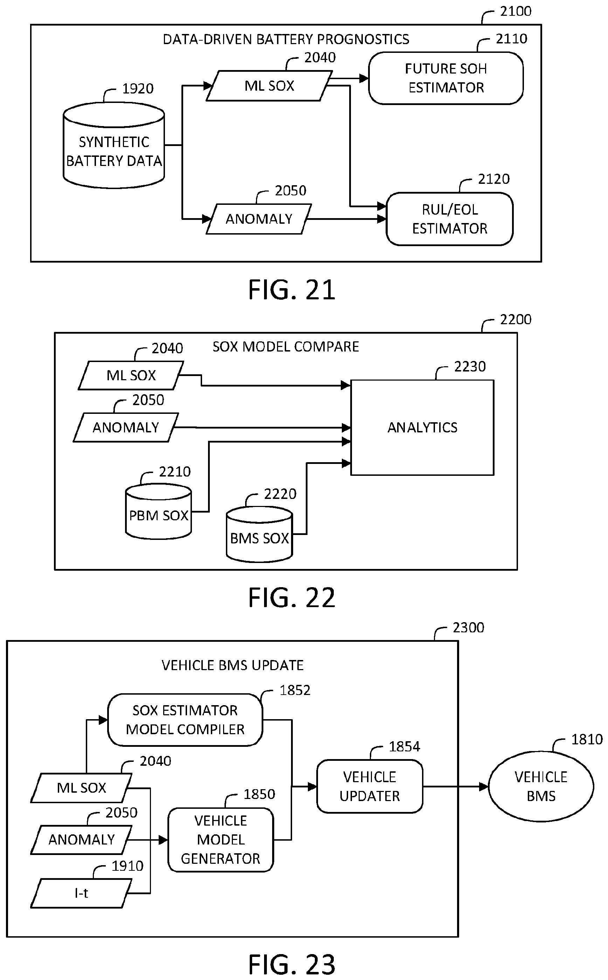

FIGS. 21-23 describe example workflows that use one or more of the I-t profile 1912 generated in the workflow of FIG. 19 or the ML SOX 2040 or Anomaly 4050 models generated in the workflow of FIG. 20, to perform various operations, in accordance with some embodiments of the present disclosure. FIG. 2100 illustrates a workflow 2100 for estimating one more prognostics for an energy storage system in accordance with some embodiments. In workflow 2100, synthetic battery data 1920 may be used to generate a trained SOX estimator model (ML SOX) 2040 and a trained anomaly detection classification model (Anomaly) 2050. An example workflow for generating ML SOX model 2040 and Anomaly model 2050 from synthetic battery data 1920 is shown and described in FIG. 20. As shown in FIG. 21, the ML SOX model 2040 may be used to generate a future estimator 2110 for the state of health (SOH) of an energy storage system. Accurately being able to estimate the SOH of a battery system may facilitate maintenance or other decisions on how to maximize and/or optimize usage of the battery system. As shown in FIG. 21, Anomaly model 2050 and ML SOX model 2040 may be used to generate a remaining useful life (RUL)/ end of life (EOL) estimator 2120 for an energy storage system. As described above, Anomaly model 2050 may be trained to estimate when a battery system may experience a catastrophic failure due to faults detected in the battery system. For instance, degradation of one or more aspects of the battery system as observed in the synthetic battery data 1920 may be used to estimate that the battery system is likely to experience catastrophic failure, and information about the estimated failure may be used, at least in part, to estimate the RUL/EOL of the battery system.

FIG. 22 illustrates a workflow 2200 for comparing different SOX models, in accordance with some embodiments of the present disclosure. For example, the performance of different ML SOX models generated with different parameters and/or architectures using the workflow shown in FIG. 20 may be compared using workflow 220. As shown, an analytics engine 2230 may receive as input the output of ML SOX model 2040, the output of Anomaly model 2050, physics-based model SOX data 2210 (e.g., battery model data 2060) and BMS SOX data 2220 (e.g., from vehicle time series data 1824). Analytics engine 2230 may be configured to compare and/or determine one or more predictions output from ML SOX model 2040 and Anomaly model 2050 based on different input values provided to the models. For example, analytics engine 2230 may be configured to compare and/or determine one or more of time parameters, battery performance parameters (e.g., SOH, SOC, SOP) for a particular battery system or for multiple battery systems, or new coefficients for one or more machine learning models that may be provided to the vehicle BMS.

As described herein, some vehicle BMS architectures may have limited compute and/or storage resources. Such limited resources may not enable modeling of a reference battery (e.g., a digital twin) on the vehicle BMS itself. Rather, modelling of digital twins corresponding to one or more reference batteries may be performed in a cloud-computing environment, and updates to one or more local models used to predict battery system performance properties (e.g., SOH, SOC, SOP) stored on the BMS for a particular vehicle may be provided as the battery system in the vehicle is used throughout its lifetime. The updates may be performed based on measured data as reported by the BMS of the vehicle and information for one or more reference batteries (e.g., digital twins) generated and/or updated using the techniques described herein. For example, the one or more reference battery models may take into account how the battery system degrades over time (e.g., using a physics-based model of the battery chemistry), and/or how driving behavior of users of the vehicle may impact the battery system performance prediction estimates.

FIG. 23 illustrates a workflow 2300 for updating a vehicle BMS using one or more trained machine learning models, in accordance with some embodiments of the present disclosure. As shown in FIG. 23, the outputs of ML SOX model 2040, Anomaly model 2050, and I-t profile 1912 may be provided as input to a vehicle model generator 1850. Vehicle model generator 1850 may be configured to learn how a particular vehicle's BMS and/or overall vehicle power system design may impact measurements (e.g., voltage, current, temperature, pressure, etc.) from the vehicle. For instance, the BMS and overall vehicle power system design may have an impact on one or more of the following: accuracy of logged historical data from the vehicle (e.g., voltage sensor accuracy ± 0.005 V), parasitic losses on the battery system under charge and discharge conditions (e.g., energy consumption of BMS), and/or limitations of active controls capabilities (e.g., passive vs. active cell balancing).

As shown in FIG. 23, the output of ML SOX model 2040 may also be provided to SOX estimator model compiler 1852, which may be configured to compile the ML SOX model 2040 into an executable model that can executed on a BMS of a particular vehicle. The complied model may be used by the vehicle BMS to make system performance property estimations. In the workflow 2300, the compiled SOX estimator model output from SOX estimator model compiler 1850 and output of the vehicle model generator 1850 may be provided as input to vehicle updater 1854 configured to provide the updated compile local SOX model to the vehicle BMS 1810 (e.g., using an IoT gateway).

In some embodiments, processes for generating updated reference battery models in a cloud-computing architecture (e.g., architecture 2000 shown in FIG. 20) and updating a local performance prediction model on a BMS based on the updated reference battery models and measured values (e.g., voltage, temperature, current, pressure) from the vehicle, may be performed throughout the lifetime of the battery system of the vehicle to provide more accurate estimates of the battery systems' performance properties compared with conventional techniques.

Having thus described several aspects of at least one embodiment, it is to be appreciated that various alterations, modifications, and improvements will readily occur to those skilled in the art. Such alterations, modifications, and improvements are intended to be within the scope of the present disclosure. Accordingly, the foregoing descriptions and drawings are by way of example only.

The above-described embodiments of the present disclosure can be implemented in any of numerous ways. For example, the embodiments may be implemented using hardware, software, or a combination thereof. When implemented in software, the software code may be executed on any suitable processor or collection of processors, whether provided in a single computer, or distributed among multiple computers.

Also, the various methods or processes outlined herein may be coded as software that is executable on one or more processors running any one of a variety of operating systems or platforms. Such software may be written using any of a number of suitable programming languages and/or programming tools, including scripting languages and/or scripting tools. In some instances, such software may be compiled as executable machine language code or intermediate code that is executed on a framework or virtual machine. Additionally, or alternatively, such software may be interpreted.

The techniques disclosed herein may be embodied as a non-transitory computer-readable medium (or multiple computer-readable media) (e.g., a computer memory, one or more floppy discs, compact discs, optical discs, magnetic tapes, flash memories, circuit configurations in Field Programmable Gate Arrays or other semiconductor devices, or other non-transitory, tangible computer storage medium) encoded with one or more programs that, when executed on one or more processors, perform methods that implement the various embodiments of the present disclosure discussed above. The computer-readable medium or media may be transportable, such that the program or programs stored thereon may be loaded onto one or more different computers or other processors to implement various aspects of the present disclosure as discussed above.

The terms "program" or "software" are used herein to refer to any type of computer code or set of computer-executable instructions that may be employed to program one or more processors to implement various aspects of the present disclosure as discussed above. Moreover, it should be appreciated that according to one aspect of this embodiment, one or more computer programs that, when executed, perform methods of the present disclosure need not reside on a single computer or processor, but may be distributed in a modular fashion amongst a number of different computers or processors to implement various aspects of the present disclosure.

Computer-executable instructions may be in many forms, such as program modules, executed by one or more computers or other devices. Program modules may include routines, programs, objects, components, data structures, etc. that perform particular tasks or implement particular abstract data types. Functionalities of the program modules may be combined or distributed as desired in various embodiments.

Also, data structures may be stored in computer-readable media in any suitable form. For simplicity of illustration, data structures may be shown to have fields that are related through location in the data structure. Such relationships may likewise be achieved by assigning storage for the fields to locations in a computer-readable medium that convey relationship between the fields. However, any suitable mechanism may be used to establish a relationship between information in fields of a data structure. For instance, pointers, tags, and/or other mechanisms may be used to establish relationship between data elements.

Various features and aspects of the present disclosure may be used alone, in any combination of two or more, or in a variety of arrangements not specifically discussed in the embodiments described in the foregoing, and are therefore not limited to the details and arrangement of components set forth in the foregoing description or illustrated in the drawings. For example, aspects described in one embodiment may be combined in any manner with aspects described in other embodiments.

Also, the techniques disclosed herein may be embodied as methods, of which examples have been provided. The acts performed as part of a method may be ordered in any suitable way. Accordingly, embodiments may be constructed in which acts are performed in an order different from illustrated, which may include performing some acts simultaneously, even though shown as sequential acts in illustrative embodiments.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Also, the phraseology and terminology used herein is for the purpose of description and should not be regarded as limiting. Use of "including," "comprising," "having," "containing," "involving," "based on," and variations thereof herein, is meant to encompass the items listed thereafter and equivalents thereof as well as additional items.

## Claims

1. A computer-implemented method for estimating an energy storage performance property of an energy system, the method comprising:
providing (1612), as input to an energy storage model and a machine learning model, sensor information associated with the energy system,
providing as input to the machine learning model, one or more values based on an output of the energy storage model; and
determining (1614) based, at least in part, on an output of the machine learning model, an estimate of the energy storage performance property,
**characterized in that**
the energy storage model comprises an empirical model and a physics-based model, the physics-based model configured to implement a plurality of mathematical equations describing physical aspects of the energy system, wherein the machine learning model is configured to receive as input, one or more first values based on a first output of the empirical model and one or more second values based on a second output of the physics-based model.

2. The method of claim 1, further comprising:
providing, as input to the machine learning model, second sensor information different from the first sensor information.

3. The method of claim 1, wherein the empirical model comprises an equivalent circuit model.

4. The method of claim 1, further comprising:
receiving measurement data for the energy system; and
determining values for one or more components of the equivalent circuit model based on the received measurement data.

5. The method of claim 1, further comprising:
receiving measurement data for the energy system; and
parameterizing the physics-based model based on the received measurement data.

6. The method of claim 5, wherein parameterizing the physics-based model comprises determining coefficient values for the plurality of mathematical equations describing physical aspects of the energy system.

7. The method of claim 1, wherein the machine learning model comprises a neural network.

8. The method of claim 7, wherein the neural network comprises a recurrent neural network.

9. The method of claim 1, wherein the energy system is a first energy system and the physics-based model is previously parameterized for a second energy system different than the first energy system.

10. The method of claim 1, wherein the energy system is a first energy system and the empirical model has values previously determined based on measurement data for a second energy system different than the first energy system.

11. The method of claim 1, wherein the energy system is a first energy system and the machine learning model is a machine learning model previously trained based on input and output data associated with a second energy system different than the first energy system.

12. A system comprising:
at least one computer processor; and
at least one computer-readable medium having stored thereon instructions which, when executed, program the at least one computer processor to perform the method of any of claims 1-11.

13. A computer-readable medium having stored thereon instructions which, when executed, program at least one computer processor to perform the method of any of claims 1-11.

## Patentansprüche

1. Computerimplementiertes Verfahren zur Abschätzung eines Leistungsmerkmals eines Energiespeichers eines Energiesystems, das Verfahren umfassend:
Bereitstellen (1612) von mit dem Energiesystem verbundenen Sensorinformationen als Eingabe für ein Energiespeichermodell und ein maschinelles Lernmodell,
Bereitstellen eines oder mehrerer Werte, die auf einer Ausgabe des Energiespeichermodells basieren, als Eingabe für das maschinelle Lernmodell; und
Bestimmen (1614) einer Schätzung des Leistungsmerkmals des Energiespeichers, zumindest teilweise basierend auf einer Ausgabe des maschinellen Lernmodells,
**dadurch gekennzeichnet, dass**
das Energiespeichermodell ein empirisches Modell und ein physikbasiertes Modell umfasst, wobei das physikalisch basierte Modell so ausgebildet ist, dass es eine Vielzahl von mathematischen Gleichungen implementiert, die physikalische Aspekte des Energiesystems beschreiben, wobei das maschinelle Lernmodell so ausgebildet ist, dass es als Eingabe einen oder mehrere erste Werte empfängt, die auf einer ersten Ausgabe des empirischen Modells basieren, und einen oder mehrere zweite Werte, die auf einer zweiten Ausgabe des physikbasierten Modells basieren.

2. Verfahren nach Anspruch 1, weiter umfassend:
Bereitstellen von zweiten Sensorinformationen, die sich von den ersten Sensorinformationen unterscheiden, als Eingabe für das maschinelle Lernmodell.

3. Verfahren nach Anspruch 1, wobei das empirische Modell ein Ersatzschaltbildmodell umfasst.

4. Verfahren nach Anspruch 1, weiter umfassend:
Empfangen von Messdaten für das Energiesystem; und
Bestimmen von Werten für eine oder mehrere Komponenten des Ersatzschaltbildmodells basierend auf den empfangenen Messdaten.

5. Verfahren nach Anspruch 1, weiter umfassend:
Empfangen von Messdaten für das Energiesystem; und
Parametrisieren des physikbasierten Modells basierend auf den empfangenen Messdaten.

6. Verfahren nach Anspruch 5, wobei das Parametrisieren des physikbasierten Modells das Bestimmen von Koeffizientenwerten für die Vielzahl von mathematischen Gleichungen umfasst, die physikalische Aspekte des Energiesystems beschreiben.

7. Verfahren nach Anspruch 1, wobei das maschinelle Lernmodell ein neuronales Netzwerk umfasst.

8. Verfahren nach Anspruch 7, wobei das neuronale Netzwerk ein rekurrentes neuronales Netzwerk umfasst.

9. Verfahren nach Anspruch 1, wobei das Energiesystem ein erstes Energiesystem ist und das physikbasierte Modell zuvor für ein zweites Energiesystem parametrisiert wurde, das sich von dem ersten Energiesystem unterscheidet.

10. Verfahren nach Anspruch 1, wobei das Energiesystem ein erstes Energiesystem ist und das empirische Modell Werte aufweist, die zuvor basierend auf Messdaten für ein zweites Energiesystem bestimmt wurden, das sich von dem ersten Energiesystem unterscheidet.

11. Verfahren nach Anspruch 1, wobei das Energiesystem ein erstes Energiesystem ist und das maschinelle Lernmodell ein maschinelles Lernmodell ist, das zuvor basierend auf Eingabe- und Ausgabedaten trainiert wurde, die mit einem zweiten Energiesystem verbunden sind, das sich von dem ersten Energiesystem unterscheidet.

12. System, umfassend:
zumindest einen Computerprozessor; und
zumindest ein computerlesbares Medium, auf dem Anweisungen gespeichert sind, die, wenn sie ausgeführt werden, den zumindest einen Computerprozessor so programmieren, dass er das Verfahren nach einem der Ansprüche 1 - 11 durchführt.

13. Computerlesbares Medium, auf dem Anweisungen gespeichert sind, die, wenn sie ausgeführt werden, zumindest einen Computerprozessor so programmieren, dass er das Verfahren nach einem der Ansprüche 1 - 11 durchführt.

## Revendications

1. Procédé mis en œuvre par ordinateur pour estimer une propriété de performance du stockage d'énergie d'un système d'énergie, le procédé comprenant :
la fourniture (1612), en tant qu'entrée à un modèle de stockage d'énergie et à un modèle d'apprentissage automatique, d'informations de capteur associées au système d'énergie,
la fourniture en tant qu'entrée au modèle d'apprentissage automatique, d'une ou plusieurs valeurs basées sur une sortie du modèle de stockage d'énergie ; et
la détermination (1614) sur la base, au moins en partie, d'une sortie du modèle d'apprentissage automatique, d'une estimation de la propriété de performance du stockage d'énergie,
**caractérisé en ce que**
le modèle de stockage d'énergie comprend un modèle empirique et un modèle basé sur la physique, le modèle basé sur la physique étant configuré pour mettre en œuvre une pluralité d'équations mathématiques décrivant des aspects physiques du système d'énergie, dans lequel le modèle d'apprentissage automatique est configuré pour recevoir en tant qu'entrée, une ou plusieurs premières valeurs basées sur une première sortie du modèle empirique et une ou plusieurs deuxièmes valeurs basées sur une deuxième sortie du modèle basé sur la physique.

2. Procédé selon la revendication 1, comprenant en outre :
la fourniture, en tant qu'entrée au modèle d'apprentissage automatique, de deuxièmes informations de capteur différentes des premières informations de capteur.

3. Procédé selon la revendication 1, dans lequel le modèle empirique comprend un modèle de circuit équivalent.

4. Procédé selon la revendication 1, comprenant en outre :
la réception de données de mesure pour le système d'énergie ; et
la détermination de valeurs pour un ou plusieurs composants du modèle de circuit équivalent sur la base des données de mesure reçues.

5. Procédé selon la revendication 1, comprenant en outre :
la réception de données de mesure pour le système d'énergie ; et
le paramétrage du modèle basé sur la physique sur la base des données de mesure reçues.

6. Procédé selon la revendication 5, dans lequel le paramétrage du modèle basé sur la physique comprend la détermination de valeurs de coefficient pour la pluralité d'équations mathématiques décrivant des aspects physiques du système d'énergie.

7. Procédé selon la revendication 1, dans lequel le modèle d'apprentissage automatique comprend un réseau neuronal.

8. Procédé selon la revendication 7, dans lequel le réseau neuronal comprend un réseau neuronal récurrent.

9. Procédé selon la revendication 1, dans lequel le système d'énergie est un premier système d'énergie et le modèle basé sur la physique est paramétré précédemment pour un deuxième système d'énergie différent du premier système d'énergie.

10. Procédé selon la revendication 1, dans lequel le système d'énergie est un premier système d'énergie et le modèle empirique présente des valeurs déterminées précédemment sur la base de données de mesure pour un deuxième système d'énergie différent du premier système d'énergie.

11. Procédé selon la revendication 1, dans lequel le système d'énergie est un premier système d'énergie et le modèle d'apprentissage automatique est un modèle d'apprentissage automatique entraîné précédemment sur la base de données d'entrée et de sortie associées à un deuxième système d'énergie différent du premier système d'énergie.

12. Système comprenant :
au moins un processeur d'ordinateur ; et
au moins un support lisible par ordinateur présentant stocké sur celui-ci des instructions qui, lorsqu'elles sont exécutées, programment l'au moins un processeur d'ordinateur pour exécuter le procédé de l'une quelconque des revendications 1 à 11.

13. Support lisible par ordinateur sur lequel sont stockées des instructions qui, lorsqu'elles sont exécutées, programment au moins un processeur d'ordinateur pour exécuter le procédé de l'une quelconque des revendications 1 à 11.
